Europäisches Patentamt

European Patent Office

Office européen des brevets

(11) Veröffentlichungsnummer: **0 617 514 A2**

# (12) EUROPÄISCHE PATENTANMELDUNG

(21) Anmeldenummer: **94200711.3**

(22) Anmeldetag: **18.03.94**

(51) Int. Cl.⁵: **H03K 23/50**

(30) Priorität: **20.03.93 DE 4308979**

(43) Veröffentlichungstag der Anmeldung:
**28.09.94 Patentblatt 94/39**

(84) Benannte Vertragsstaaten:
**DE FR GB IT**

(71) Anmelder: **Philips Patentverwaltung GmbH
Wendenstrasse 35c
D-20097 Hamburg (DE)**
(84) **DE**

(71) Anmelder: **N.V. Philips' Gloeilampenfabrieken**

**Groenewoudseweg 1
NL-5621 BA Eindhoven (NL)**
(84) **FR GB IT**

(72) Erfinder: **Suwald, Thomas, c/o Philips
Patentverwaltung GmbH
Wendenstrasse 35c
D-20097 Hamburg (DE)**

(74) Vertreter: **Peters, Carl Heinrich, Dipl.-Ing. et al
Philips Patentverwaltung GmbH,
Wendenstrasse 35c
D-20097 Hamburg (DE)**

(54) **Zähler- und/oder Teileranordnung.**

(57) Eine Zähler- und/oder Teileranordnung mit wenigstens zwei Teilzählerschaltungen, von denen jede eine Gesamtanzahl bezüglich ihrer Datenein- und -Ausgänge in Kettenschaltung angeordneter Flipflops umfaßt, wobei allen Teilzählerschaltungen ein gesames Taktsignal zugeführt wird, und mit wenigstens einem Verknüpfungsglied ermöglicht eine Darstellung beliebiger Zählvorgänge oder Teilerverhältnisse mit geringem Schaltungsaufwand bei an Schaltstörungen armem Betrieb dadurch, daß in jedem Verknüpfungsglied Signale vom Datenausgang je eines der Flipflops wenigstens eines Teils der Teilzählerschaltungen gemäß einer Und-Funktion zu einem zugehörigen resultierenden Signal verknüpft werden und jedes der resultierenden Signale wenigstens einer der Teilzählerschaltungen als Rücksetzsignal zum Überführen der Teilzählerschaltung in einen Grundzustand zugeleitet wird, wobei aus wenigstens einem der resultierenden Signale ein Ausgangssignal gebildet wird, das Produkt der Gesamtanzahlen der Flipflops aller Teilzählerschaltungen größer oder gleich einem vorgegebenen Zählmaximum bzw. Teilerverhältnis gewählt ist und die Gesamtanzahlen derart bestimmt sind, daß sie keine gemeinsamen Primfaktoren aufweisen, und wobei die mit den Verknüpfungsgliedern verbundenen Datenausgänge der Flipflops der Teilzählerschaltungen derart ausgewählt sind, daß das Ausgangssignal das vorgegebene Zählmaximum bzw. Teilerverhältnis aufweist.

Fig.1

Die Erfindung bezieht sich auf eine Zähler- und/oder Teileranordnung mit wenigstens zwei Teilzählerschaltungen, von denen jede eine Gesamtanzahl bezüglich ihrer Datenein- und -ausgänge in Kettenschaltung angeordneter Flipflops umfaßt, wobei allen Teilzählerschaltungen ein gemeinsames Taktsignal zugeführt wird, und mit wenigstens einem Verknüpfungsglied.

In der deutschen Patentanmeldung P 42 14 612.7 (PHD 92-048) ist eine Anordnung mit drei Frequenzteilerschaltungen beschrieben, die mit ihren Takteingängen gemeinsam an einen Anschluß gelegt sind, der ein in seiner Frequenz zu teilendes Taktsignal führt. Jede der Frequenzteilerschaltungen weist eine Kettenschaltung von Flipflops auf. Ein Ausgang des jeweils letzten Flipflops jeder Kettenschaltung ist mit je einem Eingang eines Und-Gatters verbunden. Dieses bildet aus den Signalen an den Ausgängen der Flipflops gemäß einer Und-Verknüpfung ein frequenzgeteiltes Ausgangssignal, welches sich nach dem Prinzip des kleinsten, gemeinsamen Vielfachen der Teilerverhältnisse der einzelnen Frequenzteilerschaltungen bestimmt. Das resultierende Teilerverhältnis ergibt sich somit aus dem Produkt der Teilerverhältnisse der einzelnen Frequenzteilerschaltungen. Dabei dürfen die Teilerverhältnisse der einzelnen Frequenzteilerschaltungen keine gemeinsamen Primfaktoren aufweisen.

Bei der in der deutschen Patentanmeldung P 42 14 612.7 (PHD 92-048) beschriebenen Anordnung wird zwar aufgrund des Aufbaus der einzelnen Frequenzteilerschaltungen, in denen gleichzeitig nur wenige, einander kompensierende oder stets in wenigstens nahezu gleicher Anzahl auftretende Schaltvorgänge erfolgen, eine gute Störunterdrückung erzielt. Die mit einer solchen Anordnung möglichen Teilerverhältnisse sind jedoch beschränkt auf solche Werte, die sich mit dem kleinsten, gemeinsamen Vielfachen der Teilerverhältnisse der einzelnen Frequenzteilerschaltungen darstellen lassen. Für die Verwirklichung von Frequenzteilerverhältnissen, die großen Primzahlen entsprechen oder solche enthalten, ist die beschriebene Anordnung nicht anwendbar oder führt zu einem unverhältnismäßig hohen Schaltungsaufwand.

Die Erfindung hat die Aufgabe, eine Zähler- und/oder Teileranordnung der eingangs genannten Art derart auszubilden, daß unter Beibehaltung eines allenfalls sehr geringe Schaltstörungen hervorrufenden Aufbaus mit geringem Schaltungsaufwand beliebige Zählvorgänge oder Teilerverhältnisse erhalten werden können.

Diese Aufgabe wird bei einer Zähler- und/oder Teileranordnung der eingangs genannten Art dadurch gelöst, daß in jedem Verknüpfungsglied Signale vom Datenausgang je eines der Flipflops wenigstens eines Teils der Teilzählerschaltungen gemäß einer Und-Funktion zu einem zugehörigen resultierenden Signal verknüpft werden und jedes der resultierenden Signale wenigstens einer der Teilzählerschaltungen als Rücksetzsignal zum Überführen der Teilzählerschaltung in einen Grundzustand zugeleitet wird, wobei aus wenigstens einem der resultierenden Signale ein Ausgangssignal gebildet wird, das Produkt der Gesamtanzahlen der Flipflops aller Teilzählerschaltungen größer oder gleich einem vorgegebenen Zählmaximum bzw. Teilerverhältnis gewählt ist und die Gesamtanzahlen derart bestimmt sind, daß sie keine gemeinsamen Primfaktoren aufweisen, und wobei die mit den Verknüpfungsgliedern verbundenen Datenausgänge der Flipflops der Teilzählerschaltungen derart ausgewählt sind, daß das Ausgangssignal das vorgegebene Zählmaximum bzw. Teilerverhältnis aufweist.

Mit der erfindungsgemäßen Zähler- und/oder Teileranordnung lassen sich die Vorteile der in der deutschen Patentanmeldung P 42 14 612.7 (PHD 92-048) beschriebenen Frequenzteilerschaltung mit dem Vorteil eines beliebig wählbaren Zählmaximums bzw. Teilerverhältnisses verbinden. Es lassen sich somit periodische Taktsignale in ein in einem beliebigen, ganzzahligen Verhältnis frequenzgeteiltes Ausgangssignal überführen, und es können beispielsweise Zählimpulse eines nicht periodischen Taktsignals bis zu einem beliebig wählbaren Zählmaximum gezählt werden. Aufgrund des Aufbaus der einzelnen Teilzählerschaltungen erfolgt im Betrieb der erfindungsgemäßen Zähler- und/oder Teileranordnung eine sehr gute Unterdrückung von Störungen mit der Frequenz der Subharmonischen des Taktsignals, aber auch eine Verringerung taktfrequenter Störungen. Dabei wird zugleich die Spitzenstromaufnahme der Zähler- und/oder Teileranordnung erheblich reduziert, was sich günstig auch auf die Dimensionierung der erforderlichen Stromversorgung auswirkt. Die gegenüber dem in der deutschen Patentanmeldung P 42 14 612.7 (PHD 92-048) beschriebenen Zählverfahren uneingeschränkte Wahl des Zählmaximums bzw. Teilerverhältnisses wird erfindungsgemäß dadurch ermöglicht, daß mindestens zwei Teilzählerschaltungen mit voneinander unterschiedlichen Moduli verwendet werden, die jeweils in Abhängigkeit vom momentanen Zählerstand der einzelnen Teilzählerschaltungen beeinflußt werden. Diese Beeinflussung wird dadurch erreicht, daß eine Teilzählerschaltung bei einem bestimmten eigenen Zählerstand sowie bei vorher festgelegten Zählerständen der anderen Teilzählerschaltungen zurückgesetzt wird, was einer Verkürzung seiner Periodenlänge entspricht. Durch Wahl dieser Verkürzung der Periodenlänge kann dann das zu verwirklichende Zählmaximum bzw. Teilerverhältnis gebildet werden.

Eine erste Fortbildung der erfindungsgemäßen Zähler- und/oder Teileranordnung mit zwei Teilzählerschaltungen sowie zwei Verknüpfungsgliedern, die je zwei Eingänge aufweisen, zeichnet sich dadurch aus, daß die Eingänge jedes Verknüpfungsgliedes mit je einem Datenausgang eines der Flipflops von je einer der Teilzählerschaltungen verbunden sind und das resultierende Signal jedes der Verknüpfungsglieder als Rücksetzsignal je einer der Teilzählerschaltungen zugeführt wird.

In einer anderen Ausgestaltung der erfindungsgemäßen Zähler- und/oder Teileranordnung werden wenigstens zwei Teilzählerschaltungen und ein Verknüpfungsglied derart miteinander gekoppelt, daß der Datenausgang je eines der Flipflops jeder Teilzählerschaltung mit je einem Eingang des Verknüpfungsgliedes verbunden ist und das resultierende Signal des Verknüpfungsgliedes als Rücksetzsignal allen Teilzählerschaltungen gemeinsam zugeführt wird.

Bei der erstgenannten Ausgestaltung der erfindungsgemäßen Zähler- und/oder Teileranordnung wird somit bei einer bestimmten Kombination von Zählerstellungen der Teilzählerschaltungen jeweils eine davon in ihren Anfangszustand zurückgesetzt. Auf diese Weise wird das gewünschte Zählmaximum bzw. Teilerverhältnis in zwei Abschnitte unterteilt, deren Längen bestimmend sind für die Wahl der mit den Eingängen der Verknüpfungsglieder zu verbindenden Datenausgänge der Flipflops. Die Länge jedes dieser Abschnitte unterteilt sich entsprechend der Wahl derjenigen Flipflops, deren Datenausgänge mit dem jeweiligen Verknüpfungsglied verbunden sind, in eine Anzahl von Durchläufen einer Teilzählerschaltung und einige zusätzliche Zählschritte bis zur Ansteuerung des Verknüpfungsgliedes über den genannten Datenausgang des Flipflops. Durch die Wahl der Flipflops, deren Datenausgänge mit den Verknüpfungsgliedern verbunden werden, sind somit hinreichend viele Freiheitsgrade geschaffen, um jedes gewünschte Zählmaximum bzw. Teilerverhältnis darstellen zu können.

Bei der letztgenannten Ausgestaltung der erfindungsgemäßen Zähler- und/oder Teileranordnung mit wenigstens zwei Teilzählerschaltungen und nur einem Verknüpfungsglied erhält man mit einem vereinfachten Aufbau zwar auch eine Verringerung der Freiheitsgrade für die Dimensionierung, jedoch reichen diese zur Wahl eines beliebigen Zählmaximums bzw. Teilerverhältnisses immer noch aus. Das erwünschte Zählmaximum (bzw. Teilerverhältnis) wird hierbei durch eine Anzahl von Zähldurchläufen einer der Teilzählerschaltungen zuzüglich einer entsprechend gewählten Anzahl einzelner Zählschritte dargestellt. Zur Identifikation der vollständig zu absolvierenden Durchläufe der genannten Teilzählerschaltung von dem Durchlauf, in dem der mit dem Verknüpfungsglied verbundene Datenausgang des ausgewählten Flipflops dieser Teilzählerschaltung das gemeinsame Rücksetzsignal auslösen soll, werden die bei dieser Zählerstellung der genannten Teilzählerschaltung durch die übrigen Teilzählerschaltungen erreichten Zählerstände im Verknüpfungsglied ebenfalls ausgewertet.

Nach einer Fortbildung der Erfindung umfaßt diese wenigstens ein weiteres Verknüpfungsglied, das mit je einem seiner Eingänge mit dem Datenausgang je eines der Flipflops jeder Teilzählerschaltung verbunden ist, sowie eine Auswahlvorrichtung, der alle resultierenden Signale zugeleitet werden und von der eines davon gemeinsam allen Teilzählerschaltungen als Rücksetzsignal zugeführt wird.

Mit einer derartigen Anordnung können in einfacher Weise mehrere unterschiedliche Zählmaxima bzw. Teilerverhältnisse erhalten werden, wobei eine Umschaltmöglichkeit zwischen diesen einzelnen Zählmaxima bzw. Teilerverhältnissen besteht. Dadurch kann mit geringem Aufwand eine umschaltbare Zähler- und/oder Teileranordnung aufgebaut werden.

Die Dimensionierung einer Zähler- und/oder Teileranordnung gemäß der Ausgestaltung der Erfindung mit wenigstens zwei Teilzählerschaltungen und einem Verknüpfungsglied erfolgt bevorzugt durch die für jede der Teilzählerschaltungen gültige Beziehung

$$qi = ((n-1) \bmod(li)) + 1,$$

wobei

i die Bezeichnung der Teilzählerschaltung,

n das Zählmaximum bzw. Teilerverhältnis,

li die Gesamtanzahl der Flipflops der i-ten Teilzählerschaltung,

qi die Numerierung des Flipflops in der Kettenschaltung der i-ten Teilzählerschaltung, dessen Datenausgang mit dem Verknüpfungsglied verbunden ist, und

mod die Modulo-Funktion

darstellt.

Diese Beziehung setzt voraus, daß zu einem vorgegebenen Zählmaximum bzw. Teilerverhältnis bereits die Gesamtanzahlen der Flipflops der einzelnen Teilzählerschaltungen festgelegt wurden, daß also die Länge dieser Teilzählerschaltungen bestimmt ist. Die Modulo-Funktion bestimmt dabei den Rest einer ganzzahligen Division. Die Bestimmung derjenigen Flipflops, deren Datenausgänge mit dem Verknüpfungsglied verbunden werden, beruht somit unmittelbar auf der Kenntnis der Gesamtanzahlen der Flipflops der Teilzählerschaltungen, welche nach einer weiteren Fortbildung der Erfindung genähert nach der Beziehung

$$li = int((n/(l1 \cdot l2 \cdot \ldots \cdot lj))^{1/(t-j)}),$$

beginnend mit

$$l1 = int((n)^{1/t}),$$

ermittelbar sind,
wobei

$$j = i-1,$$

t die Anzahl der Teilzählerschaltungen und
int die Funktion zur Rundung auf die nächstniedrigere ganze Zahl ist,
und daß die so ermittelten Werte für die Gesamtanzahlen (li) gegebenenfalls derart abgewandelt werden, daß sie untereinander keine gemeinsamen Primfaktoren besitzen, wobei das Produkt aller Gesamtanzahlen (li) der Flipflops der Teilzählerschaltungen größer oder gleich dem Zählmaximum bzw. Teilerverhältnis (n) ist.

Gemäß den vorstehend aufgeführten Beziehungen kann die Auslegung der Teilzählerschaltungen bezüglich der Gesamtanzahlen der Flipflops und der für die Verbindung mit dem Verknüpfungsglied ausgewählten Datenausgänge in zwei Schritten vorgenommen werden, wenn das gewünschte Zählmaximum bzw. Teilerverhältnis vorgegeben und außerdem die Anzahl der Teilzählerschaltungen ausgewählt wird. Das Zählmaximum bzw. Teilerverhältnis wird dabei in erster Linie durch den Einsatzzweck der gemäß der Erfindung aufzubauenden Zähler- und/oder Teileranordnung festgelegt sein. Dagegen ist die Anzahl der Teilzählerschaltungen für ein fest vorgegebenes Zählmaximum bzw. Teilerverhältnis unterschiedlich wählbar. Diese Wahl kann vorteilhaft derart getroffen werden, daß der Schaltungsaufwand insgesamt oder speziell für die Teilzählerschaltungen minimal wird. Für die Abschätzung des Schaltungsaufwandes kann nach einer weiteren Fortbildung der Erfindung die Mindestanzahl (k) aller in den Teilzählerschaltungen benötigten Flipflops aus dem (vorgegebenen) Zählmaximum bzw. Teilerverhältnis (n) gemäß

$$k = int(t \cdot (n)^{1/t}) + 1$$

näherungsweise bestimmt werden. In dieser Beziehung stellt sich die Mindestanzahl der Flipflops als Funktion der Anzahl der Teilzählerschaltungen und des Zählmaximums bzw. des Teilerverhältnisses dar. Aus dieser Funktion kann ein Minimum für die Mindestanzahl aller Flipflops und darauf aufbauend ein Minimum für den Gesamtaufwand der erfin-dungsgemäßen Zähler- und/oder Teileranordnung in Abhängigkeit von der Anzahl der Teilzählerschaltungen ermittelt werden. Dieses Minimum bzw. die zugehörige Anzahl der Teilzählerschaltungen wird dann für die Dimensionierung der einzelnen Teilzählerschaltungen herangezogen. Dabei ist zu beachten, daß die tatsächlich erreichte Anzahl aller Flipflops der Teilzählerschaltungen sich aus der Summe der Gesamtanzahlen der Flipflops der einzelnen Teilzählerschaltungen ergibt und die vorstehende Beziehung nur eine Näherungsformel zur Abschätzung der Dimensionierung darstellt. Für die Bestimmung des gesamten Schaltungsaufwandes sind außerdem die Verknüpfungsglieder zu berücksichtigen.

Vorzugsweise ist eine Zähler- und/oder Teileranordnung gemäß der Erfindung derart ausgestaltet, daß wenigstens eine der Teilzählerschaltungen eine Logikschaltung umfaßt zum Bilden eines Signals zur Beeinflussung eines einem ersten in der Kettenschaltung der Flipflops wenigstens einer der Teilzählerschaltungen zugeführten Eingangssignals in Abhängigkeit von Signalen an bestimmten Datenausgängen der Flipflops der die betreffende Logikschaltung umfassenden Teilzählerschaltung. Derartige Logikschaltungen sind bereits in der deutschen Patentanmeldung P 42 14 612.7 (PHD 92-048) beschrieben und dienen der Fehlerkorrektur insbesondere bei Inbetriebnahme der Zähler- und/oder Teileranordnung, jedoch auch zur Kompensation von Störungen während des Betriebes.

Die erfindungsgemäßen Zähler- und/oder Teileranordnungen sind vorzugsweise derart konstruiert, daß die Teilzählerschaltungen einen modularen Aufbau aufweisen mit übereinstimmenden Kettenschaltungen von Flipflops und übereinstimmenden Logikschaltungen sowie zu jeder Teilzählerschaltung einer Rücksetzsammelleitung und wenigstens einer Ausgangssammelleitung, wobei jede Ausgangssammelleitung wahlweise mit einem der Datenausgange der Flipflops zum Zuführen des Signals an diesem Datenausgang zu dem zugeordneten Verknüpfungsglied und die Rücksetzsammelleitung wahlweise mit Rücksetzeingängen eines oder mehrerer der Flipflops verbindbar sowie mit einem Dateneingang des ersten in der Kettenschaltung der Flipflops gekoppelt ist und zusätzlich wahlweise der Logikschaltung unterschiedliche, ausgewählte Signale von den Datenausgängen der Flipflops zuführbar sind.

Ein derartiger modularer Aufbau ist insbesondere dann von Vorteil, wenn eine Schaltungsanordnung mit vorgegebenem Grundaufbau möglichst einfach für verschiedene Einsatzzwecke herrichtbar sein soll. Dies ist beispielsweise der Fall bei einem Einsatz in kundenspezifischen integrierten Schaltungen. Der Grundaufbau kann dann für die unterschiedlichsten Anwendungen einheitlich einer sogenannten Bibliothek entnommen werden und ist vorzugsweise durch eine einzige, kundenspezifische sogenannte Verdrahtungsmaske, durch die den besonderen Anforderungen des gerade gewünschten Einsatzzweckes entsprechend die elektrischen Verbindungen zwischen den unviversell vorgegebenen Schaltungselementen des Grundaufbaus hergestellt werden, an den gewünschten Einsatzzweck anpaßbar. Bei der erfindungsgemäßen Zähler- und/oder Teileranordnung kann durch eine derartige Verdrahtungsmaske beispielsweise die Gesamtanzahl der Flipflops in der Kettenschaltung einer Teilzählerschaltung bestimmt werden, es kann dazu die Konfiguration der Logikschaltung, insbesondere die Anzahl der wirksamen Eingangsanschlüsse dieser Logikschaltung, die Numerierung des bzw. der Flipflops in der Kettenschaltung der betreffenden Teilzählerschaltung, dessen Datenausgang bzw. deren Datenausgange mit dem Verknüpfungsglied verbunden ist bzw. sind, sowie gegebenenfalls auch die Konfiguration des Verknüpfungsgliedes selber gewählt werden. Somit kann der modulare Aufbau entweder nur die Kettenschaltung der Flipflops sowie die zugehörige Logikschaltung umfassen, jedoch auch z.B. das Verknüpfungsglied bzw. die Verknüpfungsglieder einbeziehen.

Bevorzugt läßt sich eine Zähler- und/oder Teileranordnung der erfindungsgemäßen Art in einer Ablaufsteuerung verwenden. Dabei eignet sich die Erfindung sehr gut insbesondere zum Aufbau von störarmen und ökonomisch aufgebauten Ablaufsteuerungen auch für Hochgeschwindigkeitsanwendungen. Der Vorteil der erfindungsgemäßen Zähler-und/oder Teileranordnung liegt dabei in der einfachen Dekodierbarkeit einzelner Zählerstände durch eine einfache logische Verknüpfung je eines ausgewählten Datenausgangs jeder Teilzählerschaltung. Gegenüber herkömmlichen Ablaufsteuerungen mit einem Binärzähler und einem Dekoder wird dadurch der gegenüber dem Binärzähler erhöhte Aufwand an Flipflops durch den stark vereinfachten Dekoder schon bei der Dekodierung weniger Zählerstände ausgeglichen. Auch können gemäß der Erfindung erstellte Ablaufsteuerungen für Hochgeschwindigkeitsanwendungen auf ein sogenanntes Pipelining verzichten. Beispielsweise benötigt ein Modulo-598-Zähler mit Binärzähler und herkömmlichem Dekoder zur Dekodierung von vier Zählerständen etwa 150 Gatter, wohingegen eine Ablaufsteuerung gemäß der Erfindung für den gleichen Zweck mit 82 Gattern auskommt. Hinzu kommt der Vorteil der sehr stark verringerten Erzeugung von Impulsstörungen.

Einige Ausführungsbeispiele der Erfindung sind in der Zeichnung dargestellt und werden im nachfolgenden näher beschrieben. Es zeigen

Fig. 1 ein Ausführungsbeispiel für eine Zähler- und/oder Teileranordnung mit zwei Teilzählerschaltungen und zwei Verknüpfungsgliedern,

Fig. 2 ein weiteres Ausführungsbeispiel mit einem Verknüpfungsglied und drei oder mehr Teilzählerschaltungen,

Fig. 3 ein Ausführungsbeispiel mit zwei Teilzählerschaltungen und mehreren Verknüpfungsgliedern, über die beide Teilzählerschaltungen wahlweise zurückgesetzt werden können, und

Fig. 4 ein Beispiel für einen modularen Aufbau einer Teilzählerschaltung.

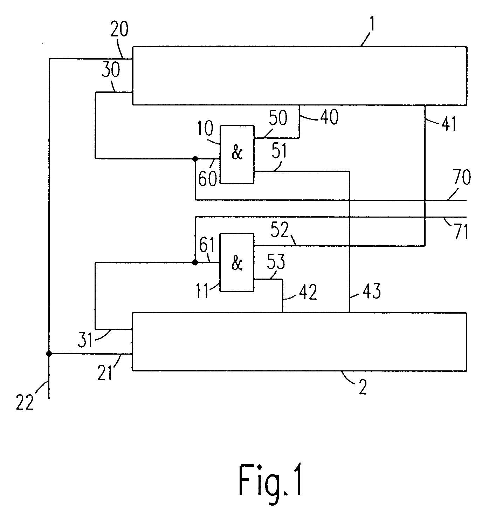

Fig. 1 zeigt als erstes Ausführungsbeispiel der Erfindung eine Zähler- und/oder Teileranordnung mit zwei Teilzählerschaltungen 1, 2 sowie zwei Verknüpfungsgliedern 10, 11, die als Und-Gatter ausgebildet sind. Jede der Teilzählerschaltungen 1, 2 weist einen Eingang 20, 21 für das Taktsignal auf; beiden Eingängen 20, 21 wird von einem gemeinsamen Taktsignalanschluß 22 ein gemeinsames Taktsignal zugeführt. Dieses gemeinsame Taktsignal fungiert als Eingangssignal, dessen Frequenz in einem vorgegebenen Teilerverhältnis zu teilen bzw. in dem Impulse, Signalflanken oder dergleichen bis zum vorgegebenen Zählmaximum zu zählen sind. Dieses Taktsignal kann periodisch oder auch nicht periodisch sein.

Jede der Teilzählerschaltungen 1, 2 weist weiterhin einen Rücksetzeingang 30, 31 auf zum Zuführen eines Rücksetzsignals, mit welchem die betreffende Teilzählerschaltung in einen Grundzustand überführt werden kann, der vorzugsweise einem Zählerstand Null der Teilzählerschaltung entspricht.

Jede der in Fig. 1 dargestellten Teilzählerschaltungen 1, 2 umfaßt eine bestimmte Gesamtanzahl bezüglich ihrer Datenein- und -ausgänge in Kettenschaltung angeordneter Flipflops. Die Datenausgänge von zwei ausgewählten Flipflops je Teilzählerschaltung 1 bzw. 2 bilden je Teilzählerschaltung 1 bzw. 2 zwei Steuerausgänge 40, 41 bzw. 42, 43. Der erste Steuerausgang 40 der ersten Teilzählerschaltung 1 ist mit einem ersten Eingang 50 des ersten Verknüpfungsgliedes 10, der zweite Steuerausgang 41 der ersten Teilzählerschaltung 1 mit einem ersten Eingang 52 des zweiten Verknüpfungsgliedes 11 verbunden, während der erste Steuerausgang 42 der zweiten Teilzählerschaltung 2 mit einem zweiten Eingang 53 des zweiten Verknüpfungsgliedes 11 und der zweite Steuerausgang 43 der zweiten Teilzählerschaltung 2 mit einem zweiten Eingang 51 des ersten Verknüpfungsgliedes 10 verbunden ist. Ein Ausgang 60 des ersten Verknüpfungsgliedes 10 ist mit dem Rücksetzeingang 30 der ersten Teilzählerschaltung 1, ein Ausgang 61 des zweiten Verknüpfungsgliedes 11 ist mit dem Rücksetzeingang 31 der zweiten Teilzählerschaltung 2 verbunden. Mit den Ausgängen 60 bzw. 61 der Verknüpfungsglieder 10 bzw. 11 sind außerdem zwei Ausgangsanschlüsse 70, 71 verbunden, an denen Ausgangssignale abgegeben werden, die gegenüber dem das Eingangssignal bildenden Taktsignal am Taktsignalanschluß 22 gemäß dem vorgegebenen Zählmaximum bzw. Teilerverhältnis der Schaltungsanordnung nach Fig. 1 in ihrer Frequenz geteilt sind. Gemäß den durch die Verknüpfungsglieder 10, 11 miteinander verknüpften, unterschiedlichen Steuerausgänge 40, 43 bzw. 41, 42 der Teilzählerschaltungen 1 bzw. 2 treten in den frequenzgeteilten Ausgangssignalen an den Ausgangsanschlüssen 70 bzw. 71 Impulse zu gegeneinander verschobenen Zeitpunkten auf.

In der Schaltungsanordnung nach Fig. 1 werden beide Teilzählerschaltungen 1, 2 durch das über den Taktsignalanschluß 22 zugeführte, gemeinsame Taktsignal synchron getaktet. In der Kettenschaltung der Flipflops jeder der Teilzählerschaltungen 1, 2 wandert dann, wie in der deutschen Patentanmeldung P 42 14 612.7 (PHD 92-048) im einzelnen dargestellt ist, ein Impuls von der Länge einer Periodendauer des Taktsignals zyklisch um, so daß beide Teilzählerschaltungen 1, 2 entsprechend der Gesamtanzahl der in ihnen in den Kettenschaltungen angeordneten Flipflops zyklisch zählen. Die Teilzählerschaltungen werden somit bevorzugt mit nicht-invertierender Rückkopplung betrieben.

Entsprechend der Anordnung der Steuerausgänge 40, 41 bzw. 42, 43 erscheinen an diesen in vorgegebenen Perioden des Taktsignals Signale von den entsprechenden Datenausgängen der Flipflops, die im folgenden als Steuersignale bezeichnet werden sollen. Diese werden in den Verknüpfungsgliedern 10 bzw. 11 zu resultierenden Signalen an den Ausgängen 60 bzw. 61 verknüpft. Das resultierende Signal vom Ausgang 60 des ersten Verknüpfungsgliedes 10 wird dem Rücksetzeingang 30 der ersten Teilzählerschaltung 1 als Rücksetzsignal zugeführt, wohingegen das resultierende Signal vom Ausgang 61 des zweiten Verknüpfungsgliedes 11 dem Rücksetzeingang 31 der zweiten Teilzählerschaltung 2 zugeleitet wird. Durch die Rücksetzsignale werden die Teilzählerschaltungen 1, 2 in denselben Grundzustand überführt, in den sie nach Durchlauf des Impulses durch alle Flipflops der Kettenschaltung, d.h. nach einem Zählzyklus bzw. Modulus, gelangen. Wenn somit durch das Steuersignal vom zweiten Steuerausgang 43 der zweiten Teilzählerschaltung 2 über den zweiten Eingang 51 des ersten Verknüpfungsgliedes 10 der Signalweg vom ersten Steuerausgang 40 der ersten Teilzählerschaltung 1 zu deren Rücksetzeingang 30 freigegeben ist, kann die erste Teilzählerschaltung 1 bereits aus dem durch das mit diesem ersten Steuerausgang 40 verbundene Flipflop bestimmten Zählerstand der ersten Teilzählerschaltung 1 in den Grundzustand rückgesetzt werden. Der erste Steuerausgang 40 entspricht somit einem verkürzten Modulus der ersten Teilzählerschaltung 1. Entsprechendes gilt für den ersten Steuerausgang 42 der zweiten Teilzählerschaltung 2. Die zweiten Steuerausgänge 41 bzw. 43 der Teilzählerschaltungen 1 bzw. 2 bestimmen, wann - d.h. in welcher Zählperiode - der verkürzte Modulus der jeweils anderen Teilzählerschaltung 2 bzw. 1 wirksam wird.

Zur Dimensionierung einer derartigen Zähler- und/oder Teileranordnung wird zunächst die Numerierung $Qa$ des Flipflops, dessen Datenausgang mit dem ersten Steuerausgang 40 der ersten Teilzählerschaltung 1 verbunden ist, sowie die Numerierung desjenigen Flipflops der zweiten Teilzählerschaltung 2, dessen Datenausgang mit dem ersten Steuerausgang 42 verbunden ist, aus einem vorgegebenen Zählmaximum bzw. Teilerverhältnis $n$ und den vorgegebenen Gesamtanzahlen $la$ und $lb$ der Teilzählerschaltungen 1 bzw. 2 gemäß den folgenden Beziehungen bestimmt:

$$Qa = ((n-1)\,mod(la)) + 1,$$
$$Qc = ((n-1)\,mod(lb)) + 1.$$

Dabei sind vorab die Gesamtanzahlen $la$, $lb$ der Teilzählerschaltungen 1, 2 derart gewählt worden, daß sie keine gemeinsamen Primfaktoren aufweisen und ihr Produkt mindestens gleich dem Zählmaximum bzw. Teilerverhältnis $n$ ist. Mit $Qa$ und $Qc$ sind die verkürzten Moduli der Teilzählerschaltungen 1, 2 bestimmt.

Im nächsten Schritt kann dann die Numerierung $Qb$ des Flipflops der ersten Teilzählerschaltung 1, dessen Datenausgang mit dem zweiten Steuerausgang 41 verbunden ist, gewählt werden. Aus den so bestimmten Größen berechnet sich dann die Numerierung $Qd$ des Flipflops, dessen Datenausgang mit dem zweiten Steuerausgang 43 der zweiten Teilzählerschaltung 2 verbunden ist, gemäß

$$Qd = ((Qc - (Qb - Qa) - 1)\,mod(Qc)) + 1.$$

In einem Dimensionierungsbeispiel ergeben sich die folgenden Werte:
$n = 7$, $1a = 4$, $1b = 5$,
$Qa = 3$, $Qb = 1$, $Qc = 2$, $Qd = 2$.

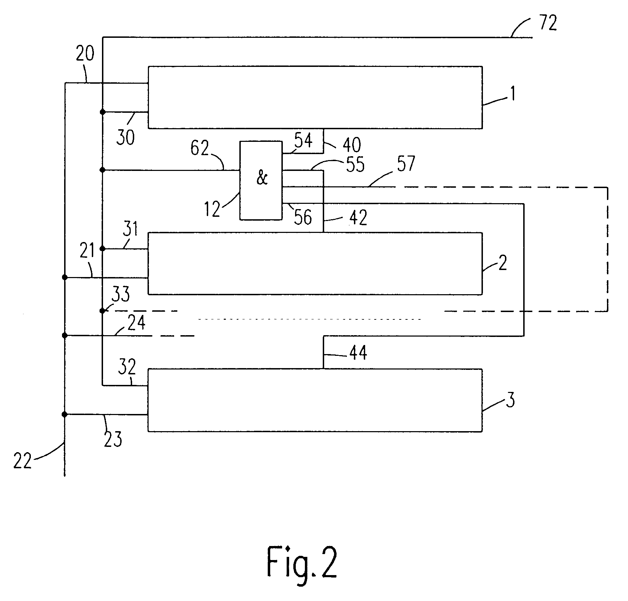

Fig. 2 zeigt ein weiteres Ausführungsbeispiel einer erfindungsgemäßen Zähler- und/oder Teileranordnung nach einer vereinfachten Ausgestaltung der erfindungsgemäßen Lehre. Diese Zähler- und/oder Teileranordnung, in der bereits beschriebene Elemente wieder mit denselben Bezugszeichen versehen sind, umfaßt drei Teilzählerschaltungen 1, 2, 3 sowie ein Verknüpfungsglied 12, welches wiederum als Und-Gatter ausgebildet ist und zu jeder der Teilzählerschaltungen 1, 2, 3 einen Eingang 54, 55 bzw. 56 aufweist. An den Teilzählerschaltungen 1, 2 ist im Ausführungsbeispiel nach Fig. 2 je nur der erste Steuerausgang 40 bzw. 42 herausgeführt und mit den Eingängen 54 bzw. 55 des Verknüpfungsgliedes 12 verbunden. Die Eingänge 20, 21 für das Taktsignal und die Rücksetzeingänge 30, 31 für das Rücksetzsignal sind bei den Teilzählerschaltungen 1, 2 gegenüber Fig. 1 unverändert. Die dritte Teilzählerschaltung 3 weist entsprechend einen Eingang 23 für das Taktsignal, einen Rücksetzeingang 32 für das Rücksetzsignal und einen ersten Steuerausgang 44 für das von ihr abgegriffene Steuersignal auf. Durch gestrichelte Linien ist weiterhin angedeutet, daß die Zähler- und/oder Teileranordnung nach Fig. 2 um weitere Teilzählerschaltungen ergänzt werden kann. Beispielsweise kann ein Eingang 24 einer weiteren Teilzählerschaltung mit dem Taktsignalanschluß 22 und ein Rücksetzeingang 33 dieser weiteren Teilzählerschaltung mit den Rücksetzeingängen 33, 31, 32 der vorstehend aufgeführten Teilzählerschaltungen verbunden werden; ein entsprechender Steuerausgang dieser weiteren, nicht dargestellten Teilzählerschaltung kann mit dem Eingang 57 des Verknüpfungsgliedes 12 verbunden werden. Entsprechend sind über weitere Anzapfungen des Taktsignalanschlusses 22 bzw. Verzweigungen der Verbindung der Rücksetzeingänge 30, 31, 32, 33 sowie zusätzlich zu schaffende Eingänge des Verknüpfungsgliedes 12 weitere Teilzählerschaltungen hinzufügbar. Für die weitere Beschreibung wird jedoch von einem Beispiel mit drei Teilzählerschaltungen 1, 2, 3 ausgegangen. Die Verbindung der Rücksetzeingänge 30, 31, 32 der Teilzählerschaltungen 1, 2, 3 ist mit einem Ausgang 62 des Verknüpfungsgliedes 12 verbunden. Dadurch wird allen Teilzählerschaltungen 1, 2, 3 gemeinsam das vom Verknüpfungsglied 12 erzeugte resultierende Signal als Rücksetzsignal zugeleitet. In der Erzeugung und Verwendung nur eines resultierenden Signals als gemeinsames Rücksetzsignal liegt auch die Vereinfachung der anhand des Ausführungsbeispiels nach Fig. 2 erläuterten, vereinfachten Ausgestaltung der erfindungsgemäßen Lehre.

Das Ausführungsbeispiel nach Fig. 2 ist für eine Verwendung als Teileranordnung mit einem Ausgangsanschluß 72 versehen, der mit dem Ausgang 62 des Verknüpfungsgliedes 12 verbunden ist und das hier zur Verfügung stehende, resultierende Signal als gegenüber dem dem Taktsignalanschluß 22 zugeführten Taktsignal frequenzgeteiltes Ausgangssignal liefert.

Für ein vorgegebenes, zu realisierendes Zählmaximum bzw. Teilerverhältnis n wird zur Schaltungsdimensionierung zunächst die Anzahl t der Teilzählerschaltungen bestimmt. Diese Anzahl t ist möglichst derart zu wählen, daß der Gesamtaufwand für die Zähler- und/oder Teileranordnung minimal wird. Als näherungsweiser Maßstab für den Gesamtaufwand kann die Mindestanzahl k aller in den Teilzählerschaltungen 1, 2, 3 usw. benötigten Flipflops herangezogen werden, die sich gemäß der Beziehung

$$k = \mathrm{int}(t \cdot (n)^{1/t}) + 1$$

näherungsweise bestimmen läßt. Die Mindestanzahl k der benötigten Flipflops als Funktion der Anzahl t der Teilzählerschaltungen weist ein Minimum auf, und der zugehörige Wert für die Anzahl t kann als Ansatz für die Schaltungsauslegung herangezogen werden. Dabei ist zu berücksichtigen, daß der Aufwand für das Verknüpfungsglied 12 mit der Anzahl t der Teilzählerschaltungen wächst.

Im nächsten Schritt der Schaltungsdimensionierung werden die Gesamtanzahlen li der Flipflops der Teilzählerschaltungen im einzelnen ermittelt. Dabei ergibt sich die Gesamtanzahl l1 der ersten Teilzählerschaltung 1 nach der Formel

$$l1 = \mathrm{int}((n^{1/t}),$$

die Gesamtanzahl l2 der nächsten (zweiten) Teilzählerschaltung 2 berechnet sich damit zu

$$l2 = \mathrm{int}((n/l1)^{1/(t-1)}).$$

Aufbauend auf den zuvor berechneten Gesamtanzahlen l1, l2,... berechnet sich die Gesamtanzahl li der i-ten Teilzählerschaltung aus der Gleichung

$$li = \mathrm{int}((n/(l1 \cdot l2 \cdot \ldots \cdot lj))^{1/(t-j)}).$$

Dabei ist j = i-1 und int die Funktion zur Rundung auf die nächstniedrigere ganze Zahl.

Im letzten Schritt kann aus den Gesamtanzahlen li der Flipflops der einzelnen Teilzählerschaltungen 1, 2, 3 usw. die Numerierung des Flipflops in der Kettenschaltung der einzelnen Teilzählerschaltung 1 bzw. 2 bzw. 3 ... bestimmt werden, dessen Datenausgang mit dem Verknüpfungsglied verbunden ist, d.h. die Anordnung des Steuerausgangs 40 bzw. 42 bzw. 44. Diese Numerierung qi bestimmt sich zu

$$qi = ((n-1)\mathrm{mod}(li)) + 1,$$

wobei mod die Modulo-Funktion darstellt. Damit sind alle Kenndaten für den Aufbau der erfindungsgemäßen Zähler- und/oder Teileranordnung zu dem gewünschten Zählmaximum bzw. Teilerverhältnis berechnet.

In einem Dimensionierungsbeispiel ist:
n = 73,
dabei ist das Minimum für die Mindestanzahl k der Flipflops mit k = 12 erreicht für t = 4. Daraus ergibt sich nach Berechnung gemäß den vorstehend erläuterten Beziehungen
$l1 = 2, l2 = 3, l3 = 3$ und $l4 = 4$.
Zur Vermeidung übereinstimmender Primfaktoren in den Gesamtanzahlen li und zur Einhaltung der Bedingung, daß das Produkt aller li mindestens gleich dem vorgegebenen Zählmaximum bzw. Teilerverhältnis n ist, wird daraus gewählt:
$l1 = 2, l2 = 3, l3 = 5, l4 = 7$.
Die tatsächliche Anzahl der Flipflops beträgt dann 17, und die Numerierungen der Flipflops, deren Datenausgänge die Steuerausgänge der Teilzählerschaltungen bilden, ergeben sich zu
$q1 = 1, q2 = 1, q3 = 3, q4 = 3$.

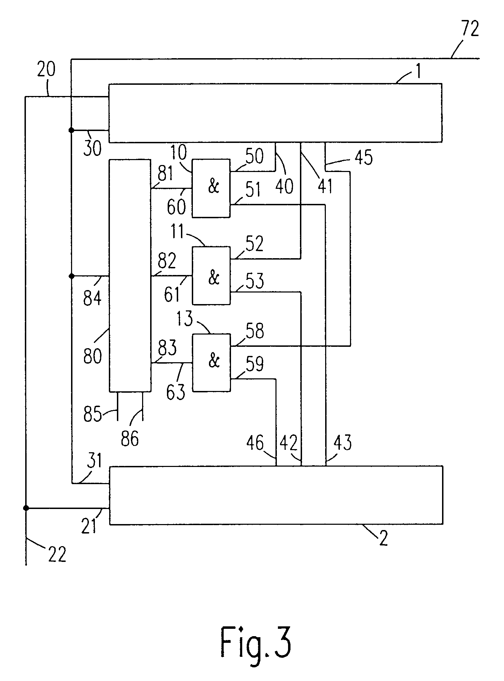

Fig. 3 zeigt eine Abwandlung der Zähler- und/oder Teileranordnung nach Fig. 2, mit der zwischen unterschiedlichen Zählmaxima bzw. Teilerverhältnissen umgeschaltet werden kann. Dazu umfaßt das Ausführungsbeispiel nach Fig. 3 zwei Teilzählerschaltungen 1, 2, die den bereits in Fig. 1 gezeigten Teilzählerschaltungen mit der Maßgabe entsprechen, daß sie noch je einen dritten Steuerausgang 45 bzw. 46 aufweisen. Die im übrigen übereinstimmenden Merkmale der Elemente in Fig. 3 sind wieder mit den aus den vorherigen Figuren bekannten Bezugszeichen versehen.

Die Schaltungsanordnung gemäß dem Ausführungsbeispiel nach Fig. 3 weist ein drittes Verknüpfungsglied 13 auf, dessen erster Eingang 58 mit dem dritten Steuerausgang 45 der ersten Teilzählerschaltung 1 und dessen zweiter Eingang 59 mit dem dritten Steuerausgang 46 der zweiten Teilzählerschaltung 2 verbunden ist. Auch das dritte Verknüpfungsglied 13 ist als Und-Gatter ausgebildet. Es ist mit seinem Ausgang 63 mit einem dritten Eingang 83 einer Auswahlvorrichtung 80 verbunden, deren erster Eingang 81 mit dem Ausgang 60 des ersten Verknüpfungsgliedes 10 und deren zweiter Eingang 82 mit dem Ausgang 61 des zweiten Verknüpfungsgliedes 11 verbunden ist. Ein Ausgang 84 der Auswahlvorrichtung 80 ist mit den miteinander verbundenen Rücksetzeingängen 30, 31 der Teilzählerschaltungen 1, 2 sowie dem Ausgangsanschluß 72 für das frequenzgeteilte Signal (Ausgangssignal) verbunden. Die Auswahlvorrichtung 80 ist vorzugsweise als Multiplexerschaltung ausgestaltet, durch die wahlweise einer der Eingänge 81, 82, 83 mit dem Ausgang 84 verbindbar ist. Auf diese Weise ist nur jeweils eines der Verknüpfungsglieder 10, 11 bzw. 13 und somit nur eines der durch ihre Beschaltungen festgelegten Zählmaxima bzw. Teilerverhältnisse wirksam. Über Umschalteingänge 85, 86 können Umschaltsignale zugeführt werden, durch die die Auswahlvorrichtung 80 in den gewünschten Schaltzustand überführt werden kann. Die Schaltungsanordnung nach Fig. 3 entspricht somit derjenigen nach Fig. 2 mit nur zwei Teilzählerschaltungen. Dabei wäre es grundsätzlich auch möglich, nur ein einziges Verknüpfungsglied mit zwei Eingängen vorzusehen und diesen die Signale von den Steuerausgängen 40, 41, 45 bzw. 42, 43, 46 über je eine Auswahlvorrichtung zuzuführen. Da jedoch der Schaltungsaufwand für die Auswahlvorrichtungen höher ist als für die Verknüpfungsglieder, ergibt sich mit der in Fig. 3 gezeigten Konfiguration ein geringerer Schaltungsaufwand.

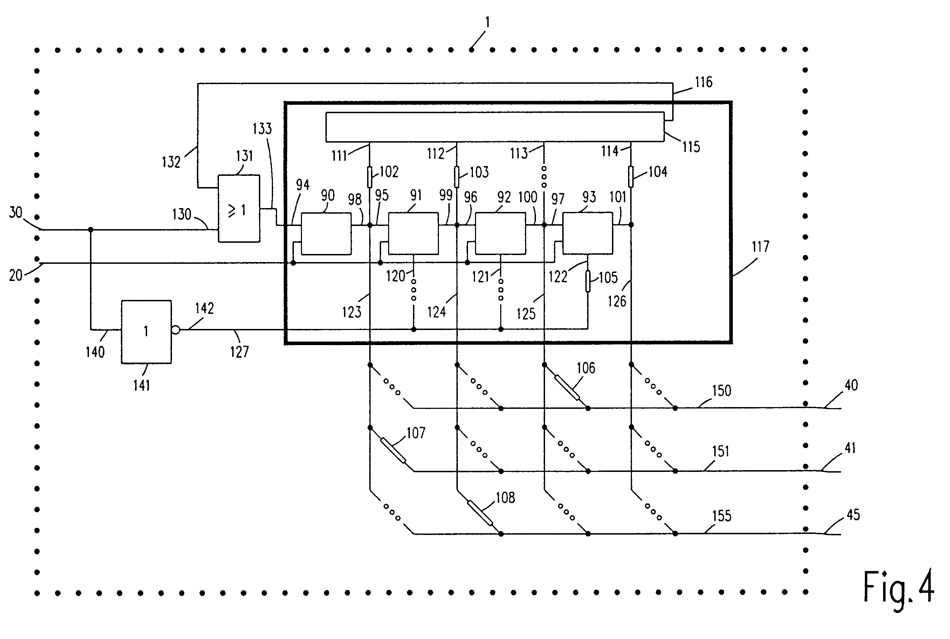

Fig. 4 zeigt ein Ausführungsbeispiel für den Aufbau einer Teilzählerschaltung, das gleichzeitig als Beispiel für deren modularen Aufbau dient. Dabei ist beispielhaft die erste Teilzählerschaltung 1 aus den Fig. 1 bis 3 herangezogen worden, wobei identische Elemente wieder mit übereinstimmenden Bezugszeichen versehen sind.

Die Teilzählerschaltung 1 nach Fig. 4 weist eine Gesamtanzahl $l1 = 4$ bezüglich ihrer Dateneingänge 94, 95, 96, 97 und ihrer Datenausgänge 98, 99, 100, 101 in Kettenschaltung angeordneter Flipflops 90, 91, 92, 93 auf. Die Flipflops 90 bis 93 sind bevorzugt vom D-Typ; ihre Takteingänge sind gemeinsam mit dem Eingang 20 für das Taktsignal verbunden. Mit den Verbindungspunkten der Datenausgänge 98, 99, 100 und der Dateneingänge 95, 96, 97 sowie mit dem Datenausgang 101 sind über wahlweise setzbare Verbindungen (Brücken) 102, 103 bzw. 104 Eingänge 111, 112, 113 bzw. 114 einer Logikschaltung 115 verbindbar. Im dargestellten Beispiel sind die Verbindungen 102, 103 bzw. 104 zum ersten, zweiten und vierten Eingang 111, 112 bzw. 114 der Logikschaltung 115 gesetzt; dadurch werden in der Logikschaltung 115 die Signale von den Datenausgängen 98, 99, 101 des ersten, zweiten und vierten Flipflops 90, 91 bzw. 93 miteinander verknüpft, wohingegen das Signal vom Datenausgang 100 des dritten Flipflops 92 unberücksichtigt bleibt, da der dritte Eingang 113 der Logikschaltung 115 nicht verbunden ist. Wie in der deutschen Patentanmeldung P 42 14 612.7 (PHD 92-048) im einzelnen ausgeführt ist, können die Verbindungen 102, 103 bzw. 104 an verschiedenen Stellen gesetzt werden.

Bis auf das erste Flipflop 90 der Kettenschaltung weisen alle Flipflops 91, 92, 93 je einen Rücksetzeingang auf, der je nach Bauart der verwendeten Flipflops auch als Freigabeeingang bezeichnet werden kann, da durch das über ihn zugeführte Signal das Flipflop je nach Bauart in einen Grundzustand zurückgesetzt bzw. an weiteren Schaltvorgängen gehindert wird. In Fig. 4 sind diese Rücksetzeingänge mit den Bezugszeichen 120, 121, 122 bezeichnet. Einzelheiten dazu sind in der deutschen Patentanmeldung P 42 42 201.9 (PHD 92-172) beschrieben. Dort ist auch ein Beispiel für den Aufbau der Flipflops 90, 91, 92, 93 angegeben, auf das hiermit ausdrücklich Bezug genommen wird.

In der Schaltungsanordnung nach Fig. 4 sind die Rücksetzeingänge 120, 121, 122 wahlweise mit einer Rücksetzsammelleitung 127 verbindbar, über die den Flipflops 91 bis 93 ein Rücksetzsignal bzw. ein Freigabesignal (je nach Ausführung des Flipflops) zugeführt werden kann, um die Teilzählerschaltung in einen Anfangszustand zu überführen. Im Ausführungsbeispiel nach Fig. 4 ist lediglich der Rücksetzeingang 122 des vierten Flipflops 93 mit der Rücksetzsammelleitung 127 über eine Verbindung 105 (Brücke) verbunden, wohingegen die Rücksetzeingänge 120, 121 des zweiten und des dritten Flipflops 91, 92 nicht verbunden sind.

Von jedem der Datenausgänge 98 bis 101 ist ein Anschluß 123, 124, 125 bzw. 126 herausgeführt, von dem wahlweise Signale einem oder mehreren Steuerausgängen 40, 41 bzw. 45 zugeführt werden können. Außerdem weist die Logikschaltung 115 einen Ausgang 116 auf, an dem ein Signal zur Beeinflussung eines dem ersten Flipflop 90 an seinem Dateneingang 94 zugeführten Eingangsignals in Abhängigkeit von den Signalen an den Eingängen 111 bis 114 abgegeben wird.

Die bisher zu Fig. 4 beschriebenen Elemente, die in der Zeichnung als Baugruppe 117 zusammengefaßt sind, sind im Prinzip in der deutschen Patentanmeldung P 42 14 612.7 (PHD 92-048) beschrieben. Sie können als Teilzählerschaltungsmodul zusammengefaßt werden.

Ein solches Teilzählerschaltungsmodul kann jedoch noch die im folgenden beschriebenen Elemente zusätzlich umfassen, wodurch sich für die gesamte Zähler- und/oder Teileranordnung konstruktive Vereinfachungen erreichen lassen. Im Ausführungsbeispiel nach Fig. 4 ist der Rücksetzeingang 30 der Teilzählerschaltung 1 einerseits mit einem ersten Eingang 130 eines Oder-Gatters 131 und andererseits mit einem Eingang 140 eines Inverters 141 verbunden. Ein zweiter Eingang 132 des Oder-Gatters 131 ist mit dem Ausgang 116 der Logikschaltung 115 verbunden, ein Ausgang 133 des Oder-Gatters 131 ist mit dem Dateneingang 94 des ersten Flipflops 90 verbunden, und ein Ausgang 142 des Inverters 141 ist an die Rücksetzsammelleitung 127 geführt. Wie in der deutschen Patentanmeldung P 42 14 612.7 (PHD 92-048) beschrieben ist, wird durch die Logikschaltung 115 über das Oder-Gatter 131 dem Dateneingang 94 des ersten Flipflops 90 ein Signal in der Weise zugeführt, daß die Kettenschaltung aus den vier Flipflops 90 bis 93 als Ringschieberegister arbeitet und außerdem fehlerhafte Schaltzustände der Flipflops 90 bis 93 korrigiert werden. Dabei wird zu Beginn eines jeden Zählzyklus von der Logikschaltung 115 über ihren Ausgang 116 und das Oder-Gatter 131 ein neuer Impuls in die Kettenschaltung der Flipflops 90 bis 93 eingespeist, der mit den folgenden Perioden des Taktsignals durch die Kettenschaltung hindurchläuft. Durch das Einspeisen des neuen Impulses in den Dateneingang 94 des ersten Flipflops 90 wird der Grundzustand der Teilzählerschaltung eingenommen. Dieser Grundzustand kann nun über den Rücksetzeingang 30 und das Oder-Gatter 131 ebenfalls durch ein von außen zugeführtes Rücksetzsignal erhalten werden, welches außerdem über den Inverter 141 das zweite bis vierte Flipflop 91 bis 93 (wahlweise) derart beeinflußt, daß dieser Grundzustand korrekt eingenommen wird.

Die Steuerausgänge 40, 41, 45 der Teilzählerschaltung 1 sind im Beispiel nach Fig. 4 mit je einer Ausgangssammelleitung 150, 151, 155 verbunden. Diese Ausgangssammelleitungen 150, 151, 155 können wahlweise über Verbindungen 106, 107, 108 (Brücken, beispielsweise in der Verdrahtungsmaske bei der Herstellung als integrierter Schaltkreis) mit den Anschlüssen 123 bis 126 verbunden werden, wobei je nach Einsatzzweck auch nur eine oder zwei der Ausgangssammelleitungen 150, 151, 155 mit stets je einem der Anschlüsse 123 bis 126 verbunden sein kann bzw. können. Bevorzugt sind die Verbindungen 102 bis 108 im selben Herstellungsschritt herstellbar.

Die in Fig. 4 gezeigte Ausführungsform einer Teilzählerschaltung kann unmittelbar anstelle der in den Fig. 1 bis 3 gezeigten Teilzählerschaltungen 1 bis 3 eingefügt werden, wobei sich eine Anpassung an die benötigte Anzahl von Steuerausgängen 40 bis 46 durch entsprechenden Anschluß der in Fig. 4 vorgesehenen Ausgangssammelleitungen 150, 151 bzw. 155 ohne weiteres Zutun ergibt. Anstelle der mit den Bezugszeichen 20, 30, 40, 41, 45 versehenen Anschlüsse des Ausführungsbeispiels der Teilzählerschaltung 1 nach Fig. 4 sind dann die entsprechenden Anschlüsse der zweiten bzw. dritten Teilzählerschaltung 2 bzw. 3 zu benennen und zu verbinden.

Durch die erfindungsgemäße Lehre wird eine Zähler- und/oder Teileranordnung erhalten, deren Aufbau eine gleichmäßige Stromaufnahme aus einer zugehörigen Stromversorgung mit sehr geringen Spitzenströmen gewährleistet. Bei einem Einsatz mit Taktsignalen hoher Frequenz ist kein sogenanntes Pipelining erforderlich. Eine erfindungsgemäß aufgebaute Zähleranordnung ermöglicht in einfachster Weise eine Dekodierung beliebiger Zählerstände. Insbesondere der modulare Aufbau der Teilzählerschaltungen als Ganzes, jedoch auch die Anordnung der einzelnen Elemente der Teilzählerschaltungen ermöglicht für die Halbleiterfertigung ein anreihbares "Layout" aus aus einer Bibliothek entnehmbaren Schaltungsvorlagen ("Zellen"). So lassen sich einerseits Teilzählerschaltungsmodule mit unterschiedlichen Gesamtanzahlen von Flipflops sehr einfach aus einer derartigen Zählbibliothek erstellen, aber auch fertige Teilzählerschaltungsmodule sind durch einfach anpaßbare Verdrahtungsmasken leicht an unterschiedliche Anforderungen, d.h. auch an unterschiedliche Gesamtanzahlen von Flipflops, anpaßbar. Das bedeutet, daß einerseits für die Teilzählerschaltungsmodule auf einem Halbleiterkörper unterschiedliche Anzahlen von Flipflops bereitgestellt werden können, aus denen wiederum je nach Wunsch durch die Verdrahtungsmaske unterschiedliche Gesamtanzahlen von Flipflops für die dann tatsächlich realisierte Teilzählerschaltung ausgewählt werden können. Dabei wird in besonders einfacher Weise der Modulus dieser Teilzählerschaltungen durch leicht variable Verbindungen (Brücke) eingestellt. Insgesamt ergibt sich somit ein stark reduzierter Aufwand für die Erstellung eines "Layout", was einen erheblichen Zeitgewinn bei der Auslegung elektronischer Schaltungen bedeutet. Auch ist das so erstellte "Layout" einfach und übersichtlich strukturiert. Derartig aufgebaute Schaltungen ermöglichen einen sicheren Betrieb, da insbesondere keine Probleme mit Laufzeiteffekten auftreten. Auch läßt sich ein derartiges "Layout" leicht korrigieren, abwandeln und somit den jeweiligen Anforderungen leicht anpassen. Auch komplexe Anordnungen, beispielsweise Ablaufsteuerungen, werden dadurch leicht überblickbar. Insbesondere bei der Verwendung für den Entwurf von Ablaufsteuerungen ergibt sich ein stark reduzierter Aufwand an logischen Schaltungen, wodurch Fläche auf dem Halbleiterkörper eingespart und die Stromaufnahme der Schaltungsanordnung verringert wird. Außerdem können Zähler- und/oder Teileranordnungen der erfindungsgemäßen Art mit allen derzeit bekannten Herstellungsverfahren aufgebaut werden, beispielsweise als CMOS-Schaltung, als bipolare Schaltung, und dergleichen.

**Patentansprüche**

1. Zähler- und/oder Teileranordnung mit wenigstens zwei Teilzählerschaltungen (1, 2, 3), von denen jede eine Gesamtanzahl (li) bezüglich ihrer Datenein- und -ausgänge (94 bis 97 und 98 bis 101) in Kettenschaltung angeordneter Flipflops (90 bis 93) umfaßt, wobei allen Teilzählerschaltungen (1, 2, 3) ein gemeinsames Taktsignal (an 22) zugeführt wird, und mit wenigstens einem Verknüpfungsglied (10, 11, 12, 13),
dadurch gekennzeichnet, daß in jedem Verknüpfungsglied (10, 11, 12, 13) Signale vom Datenausgang (98, 99, 100 bzw. 101) je eines der Flipflops (90, 91 ,92 bzw. 93) wenigstens eines Teils der Teilzählerschaltungen (1, 2, 3) gemäß einer Und-Funktion zu einem zugehörigen resultierenden Signal (an 60, 61, 62 bzw. 63) verknüpft werden und jedes der resultierenden Signale (an 60, 61, 62 bzw. 63) wenigstens einer der Teilzählerschaltungen (1, 2 bzw. 3) als Rücksetzsignal (an 30, 31, 32 bzw. 33) zum Überführen der Teilzählerschaltung (1, 2 bzw. 3) in einen Grundzustand zugeleitet wird, wobei aus wenigstens einem der resultierenden Signale (an 60, 61, 62 bzw. 63) ein Ausgangssignal (an 70, 71 bzw. 72) gebildet wird, das Produkt der Gesamtanzahlen (li) der Flipflops (90, 91, 92 bzw. 93) aller Teilzählerschaltungen (1, 2 bzw. 3) größer oder gleich einem vorgegebenen Zählmaximum bzw. Teilerverhältnis (n) gewählt ist und die Gesamtanzahlen (li) derart bestimmt sind, daß sie keine gemeinsamen Primfaktoren aufweisen, und wobei die mit den Verknüpfungsgliedern (10, 11, 12 bzw. 13) verbundenen Datenausgänge (98, 99, 100 bzw. 101) der Flipflops (90, 91, 92, 93) der Teilzählerschaltungen (1, 2 bzw. 3) derart ausgewählt sind, daß das Ausgangssignal (an 70, 71 bzw. 72) das vorgegebene Zählmaximum bzw. Teilerverhältnis (n) aufweist.

2. Zähler- und/oder Teileranordnung nach Anspruch 1 mit zwei Teilzählerschaltungen (1, 2) sowie zwei Verknüpfungsgliedern (10, 11), die je zwei Eingänge (50, 51; 52, 53) aufweisen,
dadurch gekennzeichnet, daß die Eingänge (50, 51; 52, 53) jedes Verknüpfungsgliedes (1 bzs. 2) mit je einem Datenausgang (98, 99, 100 bzw. 101) eines der Flipflops (90, 91, 92 bzw. 93) von je einer der Teilzählerschaltungen (1 bzw. 2) verbunden sind und das resultierende (an 60 bzw. 61) Signal jedes der Verknüpfungsglieder (10 bzw. 11) als Rücksetzsignal (an 30 bzw. 31) je einer der Teilzählerschaltungen (1 bzw. 2) zugeführt wird.

3. Zähler- und/oder Teileranordnung nach Anspruch 1 mit wenigstens zwei Teilzählerschaltungen (1, 2, 3) und einem Verknüpfungsglied (12),
dadurch gekennzeichnet, daß der Datenausgang (98, 99, 100 bzw. 101) je eines der Flipflops (90, 91, 92 bzw. 93) jeder Teilzählerschaltung (1, 2 bzw. 3) mit je einem Eingang (54, 55, 56 bzw. 57) des Verknüpfungsgliedes (12) verbunden ist und das resultierende Signal (an 62) des Verknüpfungsgliedes (12) als Rücksetzsignal (an 30, 31, 32) allen Teilzählerschaltungen (1, 2, 3) gemeinsam zugeführt wird.

4. Zähler- und/oder Teileranordnung nach Anspruch 3,
gekennzeichnet durch wenigstens ein weiteres Verknüpfungsglied (11, 13), das mit je einem seiner Eingänge (52, 53, 58, 59) mit dem Datenausgang (98, 99, 100 bzw. 101) je eines der Flipflops (90, 91, 92 bzw. 93) jeder Teilzählerschaltung (1, 2) verbunden ist, sowie eine Auswahlvorrichtung (80), der alle resultierenden Signale (von 60, 61, 63) zugeleitet werden und von der eines davon gemeinsam allen Teilzählerschaltungen (1, 2) als Rücksetzsignal (an 30, 31) zugeführt wird.

5. Zähler- und/oder Teileranordnung nach Anspruch 3 oder 4,
gekennzeichnet durch die für jede der Teilzählerschaltungen (1, 2, 3) gültige Beziehung

$$qi = ((n-1)mod(li)) + 1,$$

wobei

i      die Bezeichnung der Teilzählerschaltung (1, 2, 3),

n      das Zählmaximum bzw. Teilerverhältnis,

li      die Gesamtanzahl der Flipflops (90, 91, 92, 93) der i-ten Teilzählerschaltung (1, 2, 3),

qi      die Numerierung des Flipflops (90, 91, 92, 93) in der Kettenschaltung der i-ten Teilzählerschaltung (1, 2, 3), dessen Datenausgang (98, 99, 100, 10) mit dem Verknüpfungsglied (10, 11, 12, 13) verbunden ist, und

mod      die Modulo-Funktion

darstellt.

6. Zähler- und/oder Teileranordnung nach Anspruch 3, 4 oder 5,
dadurch gekennzeichnet, daß die Gesamtanzahlen (li) der Flipflops (90, 91, 92, 93) der Teilzählerschaltungen (1, 2, 3) genähert nach der Beziehung

$$li = int((n/(l1 \cdot l2 \cdot \ldots \cdot lj))^{1/(t-j)}),$$

beginnend mit

$$l1 = int((n)^{1/t}),$$

ermittelbar sind,
wobei

j = i-1,

t      die Anzahl der Teilzählerschaltungen (1, 2, 3) und

int      die Funktion zur Rundung auf die nächstniedrigere ganze Zahl

ist, und daß die so ermittelten Werte für die Gesamtanzahlen (li) gegebenenfalls derart abgewandelt werden, daß sie untereinander keine gemeinsamen Primfaktoren besitzen, wobei das Produkt aller Gesamtanzahlen (li) der Flipflops (90, 91, 92, 93) der Teilzählerschaltungen (1, 2, 3) größer oder gleich dem Zählmaximum bzw. Teilerverhältnis (n) ist.

7. Zähler- und/oder Teileranordnung nach Anspruch 3, 4, 5 oder 6,
dadurch gekennzeichnet, daß die Mindestanzahl (k) aller in den Teilzählerschaltungen (1, 2, 3) benötigten Flipflops (90, 91, 92, 93) aus dem (vorgegebenen) Zählmaximum bzw. Teilerverhältnis (n) gemäß

$$k = int(t \cdot (n)^{1/t}) + 1$$

näherungsweise bestimmbar ist.

8. Zähler- und/oder Teileranordnung nach einem der vorhergehenden Ansprüche,
dadurch gekennzeichnet, daß wenigstens eine der Teilzählerschaltungen (1, 2, 3) eine Logikschaltung (115) umfaßt zum Bilden eines Signals (an 116) zur Beeinflussung eines einem ersten (90) in der Kettenschaltung der Flipflops (90 bis 93) wenigstens einer der Teilzählerschaltungen (1, 2, 3) zugeführten Eingangssignals (an 94) in Abhängigkeit von Signalen an bestimmten Datenausgängen (98, 99, 100 bzw. 101) der Flipflops (90, 91, 92 bzw. 93) der die betreffende Logikschaltung (115) umfassenden Teilzählerschaltung (1 bzw. 2 bzw. 3).

9. Zähler- und/oder Teileranordnung nach einem der vorhergehenden Ansprüche,
dadurch gekennzeichnet, daß die Teilzählerschaltungen (1, 2, 3) einen modularen Aufbau aufweisen mit übereinstimmenden Kettenschaltungen von Flipflops (90, 91, 92, 93) und übereinstimmenden Logikschaltungen (115) sowie zu jeder Teilzählerschaltung (1, 2, 3) einer Rücksetzsammelleitung (127) und wenigstens einer Ausgangssammelleitung (150, 151, 155), wobei jede Ausgangssammelleitung (150, 151 bzw. 155) wahlweise mit einem der Datenausgänge (98, 99, 100 bzw. 101) der Flipflops zum zuführen des Signals an diesem Datenausgang zu dem zugeordneten Verknüpfungsglied und die Rücksetzsammelleitung (127) wahlweise mit Rücksetzeingangen (120, 121 bzw. 122) eines oder mehrerer der Flipflops (91, 92, 93) verbindbar sowie mit einem Dateneingang des ersten in der Kettenschaltung der Flipflops gekoppelt ist und zusätzlich wahlweise der Logikschaltung (115) unterschiedliche, ausgewählte Signale (an 111 bis 114) von den Datenausgängen (98 bis 101) der Flipflops (90 bis 93) zuführbar sind.

10. Zähler- und/oder Teileranordnung nach einem der vorhergehenden Ansprüche, gekennzeichnet durch eine Verwendung in einer Ablaufsteuerung.

Fig.1

Fig.2

Fig.3

Fig.4

EP 0 617 514 A2